# EUROPÄISCHE PATENTSCHRIFT

(11) **EP 1 151 508 B1**
(45) Veröffentlichungstag und Bekanntmachung des Hinweises auf die Patenterteilung: **20.11.2002**
(21) Anmeldenummer: 00914078.1
(22) Anmeldetag: 09.02.2000
(51) Int. Cl.: H01S 5/10, H01S 3/08

(54) **RESONATORANORDNUNG MIT MINDESTENS ZWEI FALTUNGSELEMENTEN**
RESONATOR SYSTEM WITH AT LEAST TWO FOLDING ELEMENTS
DISPOSITIF RESONATEUR COMPORTANT AU MOINS DEUX ELEMENTS DE REPLIEMENT

(30) Priorität: 09.02.1999 DE 19905218
(43) Veröffentlichungstag der Anmeldung: 07.11.2001
(73) Patentinhaber: FRAUNHOFER-GESELLSCHAFT ZUR FÖRDERUNG DER ANGEWANDTEN FORSCHUNG E.V., 80636 München (DE)
(72) Erfinder: DU, Keming, D-52078 Aachen (DE); LOOSEN, Peter, D-52076 Aachen-Kornelimünster (DE); POPRAWE, Reinhart, D-52074 Aachen (DE); BOUCKE, Konstantin, D-52074 Aachen (DE)
(74) Vertreter: Grimm, Ekkehard, Dipl.-Phys.
(86) Internationale Anmeldenummer: EP0001041
(87) Internationale Veröffentlichungsnummer: WO00048277

(56) Entgegenhaltungen:
- EP-A- 0 533 390
- FR-A- 2 739 982
- US-A- 3 883 888
- PATENT ABSTRACTS OF JAPAN vol. 005, no. 137 (E-072), 29. August 1981 (1981-08-29) & JP 56 073485 A (FUJITSU LTD), 18. Juni 1981 (1981-06-18)
- PATENT ABSTRACTS OF JAPAN vol. 017, no. 570 (E-1448), 15. Oktober 1993 (1993-10-15) & JP 05 167197 A (HAMAMATSU PHOTONICS KK), 2. Juli 1993 (1993-07-02)
- PEZESHKI B ET AL: "MULTIPLE WAVELENGTH LIGHT SOURCE USING AN ASYMMETRIC WAVEGUIDE COUPLER" APPLIED PHYSICS LETTERS,US,AMERICAN INSTITUTE OF PHYSICS. NEW YORK, Bd. 65, Nr. 2, 11. Juli 1994 (1994-07-11), Seiten 138-140, XP000458769 ISSN: 0003-6951

## Beschreibung

Die vorliegende Erfindung betrifft eine Resonatoranordnung mit mindestens zwei Faltungselementen zur Faltung des Strahlengangs, wobei die Faltungselemente zur Einschränkung des Divergenzwinkels der Strahlung dienen.

Der einfachste optische Resonator ist der sogenannte Fabry-Resonator, der aus parallel zueinander angeordneten Spiegeln besteht. Zwischen den beiden plan-parallel angeordneten Spiegeln wird derjenige Strahl, der senkrecht auf die Spiegel einfällt, ohne Richtungsänderung hin und her reflektiert. Wird zwischen den beiden Resonatorspiegeln ein verstärkendes Medium plaziert, so kann der Strahl hoch verstärkt werden. Die Auskopplung erfolgt durch einen der beiden Spiegel, der hierzu teildurchlässig ausgebildet ist. Andere Strahlen, die abweichend vom senkrechten Einfall auf die Resonatorspiegel treffen, werden nach wenigen Umläufen aus dem Resonator herausreflektiert. Dadurch erfährt der Strahl, der senkrecht auf die Resonatorspiegel fällt, die maximale Verstärkung. Auf diese Weise setzt sich dieser Strahl gegen die anderen Strahlen durch. Damit selektiert der Resonator den senkrecht zu den Spiegeln verlaufenden Strahl infolge der höheren Verstärkung.

Es gibt in der Praxis zahlreiche verschiedene Laser, in denen Medien mit unterschiedlichen Eigenschaften zur Verstärkung eingesetzt werden. So gibt es Lasermedien mit einem geringen Verstärkungsfaktor, wie z.B. Cr:LiSaF, und Lasermedien mit einem extrem hohen Verstärkungsfaktor, wie z.B. im Fall des Diodenlasers. Für Lasermedien mit geringem Verstärkungsfaktor müssen Resonatoren mit einer hohen Güte aufgebaut werden, um einen effizienten Laserbetrieb zu gewährleisten. In diesem Fall reicht oft ein Resonator aus, der aus zwei Spiegeln besteht, um die nötige Modenselektion zu erreichen.

Der Diodenlaser hat andererseits einen extrem hohen Verstärkungsfaktor. Um einen hohen Wirkungsgrad zu erreichen, muß ein großer Teil der im Resonator umlaufenden Strahlung ausgekoppelt werden. So besteht der Resonator eines Halbleiterlasers typischerweise aus einem Endspiegel mit einer Reflexion von ca. 95% und einem Auskoppler mit einer Reflexion von ca. 5%. Dazu kommt die hohe Verstärkung im Vergieich zu konventionellen Lasern. Dadurch bedingt ist die Resonatorgüte minimal und damit die Modenselektionsfähigkeit gering. Dies bedeutet, daß auch Moden mit geringer Strahlqualität entstehen werden.

Eine erhöhte Modenselektion kann z.B. durch eine Apertur erreicht werden. Es gibt grundsätzlich zwei verschiedene Aperturen: zum einen die Blende (Modenblende) und zum anderen die Soft-Verstärkungsapertur (Gain-Guiding).

Für eine erhöhte Modenselektion in Diodenlasern werden in der US-A- 5,231,642 periodische Gitterstrukturen oder verteilte Reflexionsstrukturen verwendet. Die dabei verwendete Struktur kann durch einen photolithographischen Prozeß erzeugt werden. Die Funktion der periodischen Gitterstrukturen oder der verteilten Reflexionsstrukturen besteht darin, zum einen die Modenselektionsfähigkeit zu steigern und zum anderen die Filamentierung zu reduzieren. Die Reflexion an den Gitterstrukturen, wie sie aus der US-A- 5,231,642 bekannt sind, beruht auf konstruktiver Interferenz nach dem Bragg-Prinzip. Grundsätzlich sind derartige Gitter oder Gitterstrukturen schwierig zu fertigen, es treten starke Verluste an den Grenzflächen auf, gerade wenn sie nicht exakt gefertigt sind, sie ergeben unter Umständen relativ große Baugruppen und schließlich zeigen Gitter eine Wellenlängenabhängigkeit der Reflexionseigenschaften.

Patent Abstracts of Japan, vol. 005, no. 137 (E-072), 29 August 1981 & JP-A-56 073 485 offenbaren eine Resonatoranordnung gemäß dem Oberbegriff des Anspruchs 1.

Ausgehend von dem vorstehend beschriebenen Stand der Technik liegt der vorliegenden Erfindung die Aufgabe zugrunde, eine Resonatoranordnung anzugeben, mit der wellenlängenunabhängig der Divergenzwinkel der Strahlung innerhalb der Resonatoranordnung geändert bzw. reduziert werden kann.

Diese Aufgabe wird bei einer Resonatoranordnung gemäß Anspruch 1 dadurch gelöst, daß die Strahlachse der Strahlungund die Flächennormale der jeweiligen reflektierenden Fläche unter einem Winkel zueinanderstehen, der größer als der Grenzwinkel für Totalreflexion, allerdings kleiner als die Summe aus Grenzwinkel für Totalreflexion und Divergenzwinkel der Strahlung ist.

Eine solche Anordnung zeichnet sich dadurch aus, daß insgesamt ein stark winkelabhängiger Reflexionsgrad entsteht, so daß der Divergenzwinkel der im so gestalteten Resonator umlaufenden Strahlung eingeschränkt wird, ohne auf die Bragg-Reflexion an einem Gitter mit den genannten Nachteilen zurückgreifen zu müssen.

In einer bevorzugten Weiterbildung der Resonatoranordnung wird die jeweilige, reflektierende Fläche durch die Grenzfläche zwischen Materialien mit unterschiedlichen Brechungsindizes gebildet. Diese Anordnung eignet sich insbesondere für Festkörperlaser mit gläsernem oder kristallinem Verstärkungsmedium sowie für Halbleiterlaser.

Weiterhin kann es von Vorteil sein, daß in der Resonatoranordnung teilweise eine Wellenführung durch eine Wellenleiterstruktur erfolgt und daß die jeweilige reflektierende Fläche durch eine Änderung des Profils der Wellenleiterstruktur gebildet ist. Eine solche Anordnung sollte immer dann herangezogen werden, wenn beispielsweise die Höhe des Wellenleiterprofils auf einfache Weise variiert werden kann. Zum Beispiel erfolgt die Wellenführung in Halbleiterlasern in vertikaler Richtung durch eine als Wellenleiter ausgebildete Schichtstruktur. Das Wellenleiterprofil kann in diesem Fall durch Abätzen oberer Schichten verändert werden.

Um einen kompakten Aufbau und, auch ohne Verspiegelung einer Resonatorendfläche, eine Auskopplung der Strahlung nur in einer Richtung zu erzielen, werden zumindest die Faltungselemente so zueinander angeordnet, daß ein Resonatorendspiegel und ein Resonatorauskoppler in einer Ebene liegen.

In einer weiteren, bevorzugten Ausführungsform wird mindestens eines der Faltungselemente der Resonatoranordnung mit einer für die Strahlung teiltransparenten, plan-parallelen Schicht versehen. Hierbei sollte diese teiltransparente, plan-parallele Schicht so aufgebaut werden, daß ein Teil der auftreffenden Strahlung in dieser Schicht wellenleiterartig geführt wird und so ein Strahlungstransport transversal zur bevorzugten Ausbreitungsrichtung der Strahlung erfolgt. Dies kann zur Homogenisierung des Strahlungsfeldes beitragen.

Bevorzugt wird der Verstärkungsbereich so ausgelegt, daß er nur einen Teil des durch die einfache oder mehrfache Faltung gebildeten Resonatorvolumens einnimmt.

Um die Ausbildung unerwünschter Strahlverteilungen zu vermeiden, werden in dem Resonatorvolumen liegende Bereiche, die nicht als Verstärkungszone ausgebildet sind, mit zusätzlicher Absorption versehen.

In einer besondere Ausgestaltung der Resonatoranordnung ist eine Verstärkungszone vorgesehen, die schichtartig ausgebildet ist, wobei die Faltung in einer Ebene senkrecht zu der Schicht vorgenommen ist. Eine solche Resonatoranordnung bringt Vorteile dahingehend mit sich, daß trotz der geringen Dicke des Verstärkungsbereichs die Strahlungsauskopplung über eine vergleichsweise deutlich größere Querschnittsfläche erfolgen kann.

Es sind Fälle denkbar, bei denen gefordert wird, daß die Ausdehnung der Verstärkungsbereiche unterhalb gegebener Grenzwerte bleibt, beispielsweise um eine verbesserte Wärmeabfuhr zu ermöglichen. Um dies zu erreichen, wird im Bereich einzelner Faltungselemente jeweils ein getrennter Verstärkungsbereich angeordnet.

Um eine zusätzliche Strahlformung, insbesondere hinsichtlich einer Beeinflussung des Divergenzwinkels, zu erzielen, können einzelne der reflektierenden Flächen mit einer zusätzliche Krümmung versehen werden.

Zum Aufbau eines Ringresonators werden mindestens drei geeignet positionierte und zueinander ausgerichtete Faltungselemente vorgesehen.

Weiterhin kann parallel zu den reflektierenden Flächen mindestens eines Teils der Faltungselemente ein Verstärkungsmedium angeordnet werden. Dies hat auch den Vorteil, daß die Strahlfilamentierung in den Verstärkungsbereichen verringert werden kann.

In Verbindung mit einer Resonatoranordnung, bei der mindestens eines der Faltungselemente mit einer für die Strahlung teiltransparenten, plan-parallelen Schicht versehen ist, kann diese plan-parallele Schicht durch eine weitere Grenzfläche zwischen Medien mit unterschiedlichen Brechungsindizes gebildet werden.

Weitere Einzelheiten und Merkmale der Erfindung ergeben sich aus der nachfolgenden Beschreibung von verschiedenen Ausführungsbeispielen anhand der Zeichnungen. In den Zeichnungen:
- Figur 1: zeigt eine Resonatoranordnung in Form eines linearen Resonators mit zweifacher Faltung, wobei die Faltung durch die interne Totalreflexion eines entsprechenden Brechungsindexprofils erreicht wird,
- Figur 2A: zeigt ein beispielhaftes Diagramm eines Reflexionsgrads in Abhängigkeit vom Einfallswinkel,
- Figur 2B: zeigt den Einfallswinkel, wie er auf der x-Achse des Diagramms von Figur 2A aufgetragen ist,
- Figur 3A: zeigt ein Diagramm zur Abhängigkeit des Reflexionsgrads für einen linearen Resonator mit zweifacher Faltung, wobei
- Figur 3B: den Strahlengang für einen halben Resonatorumlauf mit zweimaliger Reflexion an einem der Faltungselemente angibt,
- Figur 4A: zeigt den schematischen Aufbau eines dreifach gefalteten Resonators,
- Figur 4B: zeigt die Abhängigkeit der Reflektivität vom Einfallswinkel für einen Umlauf in dem in Figur 4A dargestellten Resonator,
- Figur 5: zeigt schematisch einen Schnitt entlang der Schnittlinie V-V in Figur 1,
- Figur 6: zeigt schematische einen zweifach gefalteten Resonator, bei dem der Brechungsindex an dem jeweiligen Faltungselement drei Stufen aufweist, und so eine plan-parallele Schicht zu dem Faltungselement gebildet wird,
- Figur 7: zeigt schematisch einen Schnitt entlang der Schnittlinie VII-VII in Figur 6,
- Figur 8: zeigt schematisch einen sechsfach gefalteten Ringresonator, wobei die Auskopplung der Strahlung durch Leckstrahlung in einer äußeren Platte erfolgt,
- Figur 9: zeigt einen sechsfach gefalteten Resonator entsprechend der Figur 8, wobei allerdings die Auskopplung durch Leckstrahlung in einem Prisma erfolgt,
- Figur 10: zeigt schematisch einen achtfach gefalteten Ringresonator,
- Figur 11: zeigt schematisch einen sechsfach gefalteten Ringresonator, vergleichbar mit der Anordnung der Figur 9, allerdings mit paralleler Auskopplung über zwei Prismen,
- Figur 12: zeigt eine beispielhafte Darstellung der Geometrie des Verstärkungsbereichs (Gain-Zone) für einen zweifach gefalteten Resonator, wie er beispielsweise in Figur 6 dargestellt ist,
- Figur 13: zeigt einen weiteren, zweifach gefalteten Resonator, schematisch dargestellt, mit streifenförmigen Verstärkungsbereichen,
- Figur 14: zeigt ein Feld bzw, Array aus zweifach gefalteten Resonatoren,
- Figur 15: zeigt einen Resonator mit Faltung in der Ebene senkrecht zur Schichtebene, wobei der Resonator mehrere, axial angeordnete Verstärkungszonen aufweist, und
- Figur 16: zeigt schematisch einen Resonator für eine schichtförmige Verstärkungszone mit einer Faltung in der Ebene senkrecht zu der Verstärkungsschicht.

Der Grundgedanke des Resonatoraufbaus, wie er in den nachfolgend beschriebenen Figuren gezeigt ist, liegt darin, daß der Resonator mittels mindestens zwei optischer Elemente bzw. reflektierender Flächen gefaltet wird, wobei die Faltungselemente so ausgelegt sind, daß deren Reflektivität eine definierte und starke Winkelabhängigkeit aufweist.

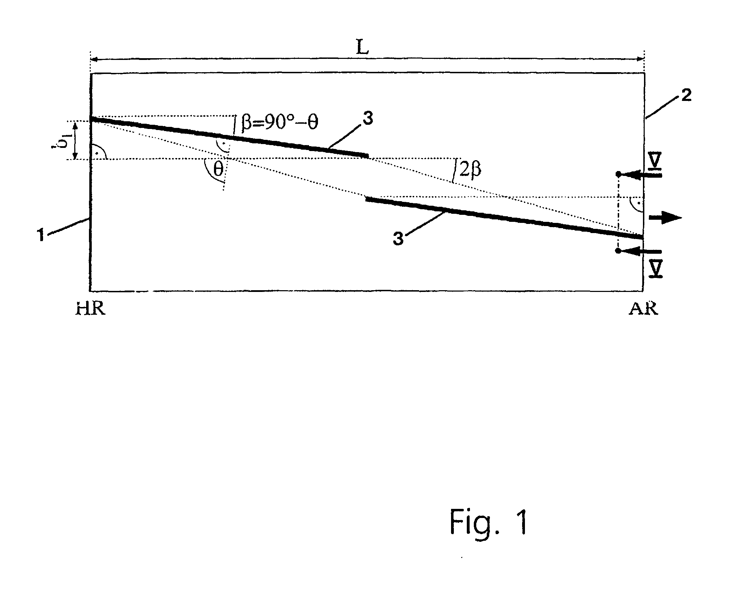

In Figur 1 ist ein Resonator mit einer Resonatorlänge L, festgelegt durch die Beabstandung der beiden Resonatorendspiegel 1, 2, dargestellt. Dieser Resonator ist durch zwei Faltungselemente 3 gefaltet. Durch die Positionierung dieser beiden Faltungselemente 3 innerhalb des Resonators ergibt sich ein linearer, zweifach gefalteter Resonator mit einer "Z-Geometrie". Das Strahfungsfeld in dem Resonator der Figur 1 besteht aus Anteilen, die sich parallel zur optischen Achse ausbreiten, und Anteilen, die sich infolge der totalen Reflexion an den Faltungselementen 3 bzw. den entsprechenden reflektierenden Flächen unter dem doppelten Reflexionswinkel zur Resonatorachse ausbreiten. Damit nur die parallel zur optischen Achse verlaufenden Strahlen auf den Auskoppler bzw. den Resonatorendspiegel 2, der teilweise antireflektierend beschichtet ist, treffen, sind die total reflektierenden Grenzflächen über nur einen entsprechend bestimmten Teil der Resonatorlänge ausgebildet, wie dies auch in Figur 1 zu sehen ist.

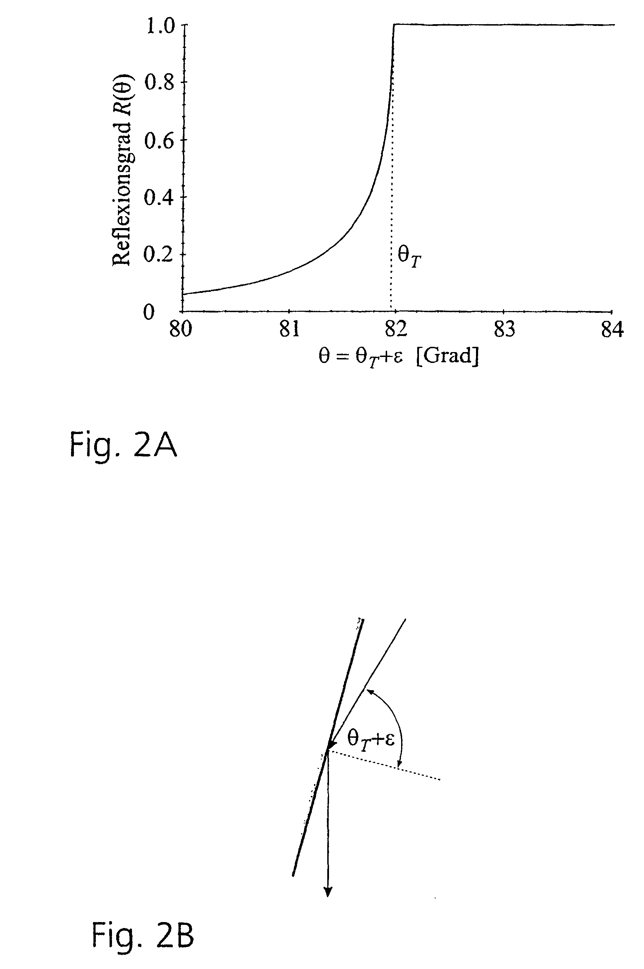

Betrachtet man die graphische Darstellung der Figur 2A, so zeigt sich, daß für Einfallswinkel nahe dem Grenzwinkel für Totalreflexion die Grenzfläche eine stark winkelabhängige Reflektivität aufweist. Hierbei stellt θ den Reflexionswinkel dar, θ_{T} bezeichnet den Grenzwinkel für Totalreflexion, der, entsprechend der Graphik der Figur 2A, für eine angenommene reflektierende Schicht 82 Grad beträgt, und wobei ε die Differenz zwischen θ und θ_{T} bezeichnet. Der Winkel θ_{T} + ε ist in Figur 2B nochmals veranschaulicht.

Anhand der Figur 2 A ist ersichtlich, daß dann, wenn die Faltung eines Resonators, wie er auch in Figur 1 dargestellt ist, so ausgelegt wird, daß die Resonatorachse und die Flächennormale auf die Faltungsfläche unter einem Winkel zueinander stehen, der geringfügig größer als der Grenzwinkel für die Totalreflexion ist, durch die Totalreflexion der Divergenzwinkel der Laserstrahlung einseitig um die Resonatorachse eingeschränkt wird. Bei einem linearen Resonator wird der Strahl an dem Resonatorspiegel 1 (siehe Figur 1) reflektiert und dadurch der Divergenzwinkel des Strahls hinsichtlich der Resonatorachse gespiegelt. Für den zurücklaufenden Strahl wird daher durch die Totalreflexion der Reflexionwinkel zur anderen Seite hin eingeschränkt. Somit kann durch die zweimalige Totalreflexion der zulässige Divergenzwinkel um die Resonatorachse selektiert werden.

Es sollte angemerkt werden, daß in den Zeichnungen an den jeweiligen Spiegeln, so auch an den Resonatorspiegeln 1 und 2, die Angabe "HR" jeweils "hoch reflektierend" bedeutet, während die Angabe "AR" jeweils "antireflektierend" aussagt.

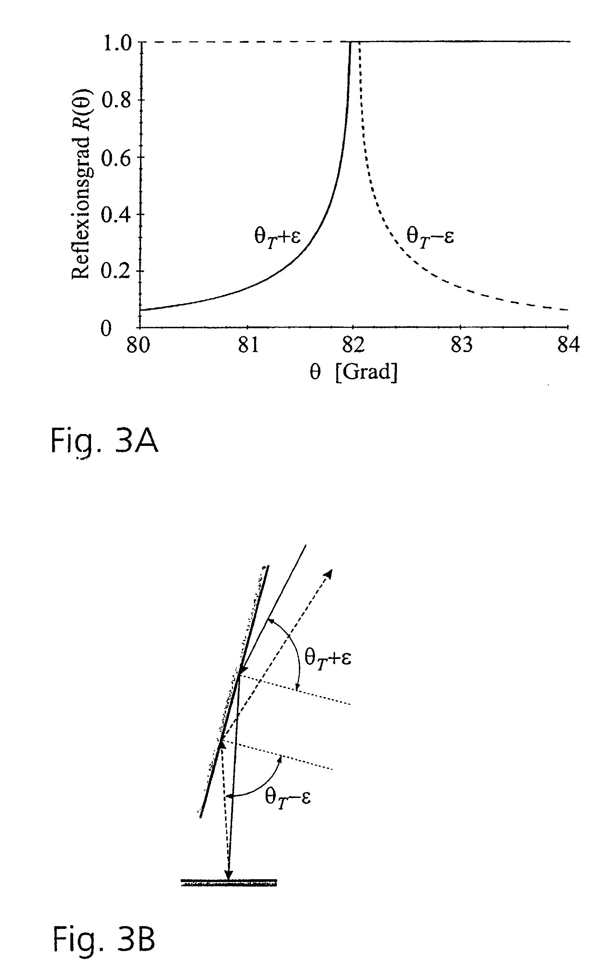

Anhand der Figuren 3A und 3B ist zu erkennen, daß die Reflexion für Laserstrahlen parallel zur Resonatorachse maximal wird, während die Strahlung, deren Richtung von der Resonatorachse abweicht, größere Transmissionsverluste aufweist.

Das Strahlungsfeld in dem Resonator 1 besteht aus Anteilen, die sich parallel zur optischen Achse ausbreiten, und Anteilen, die sich infolge der Totalreflexion an den Faltungsflächen unter dem doppelten Reflexionswinkel zur Resonatorachse ausbreiten.

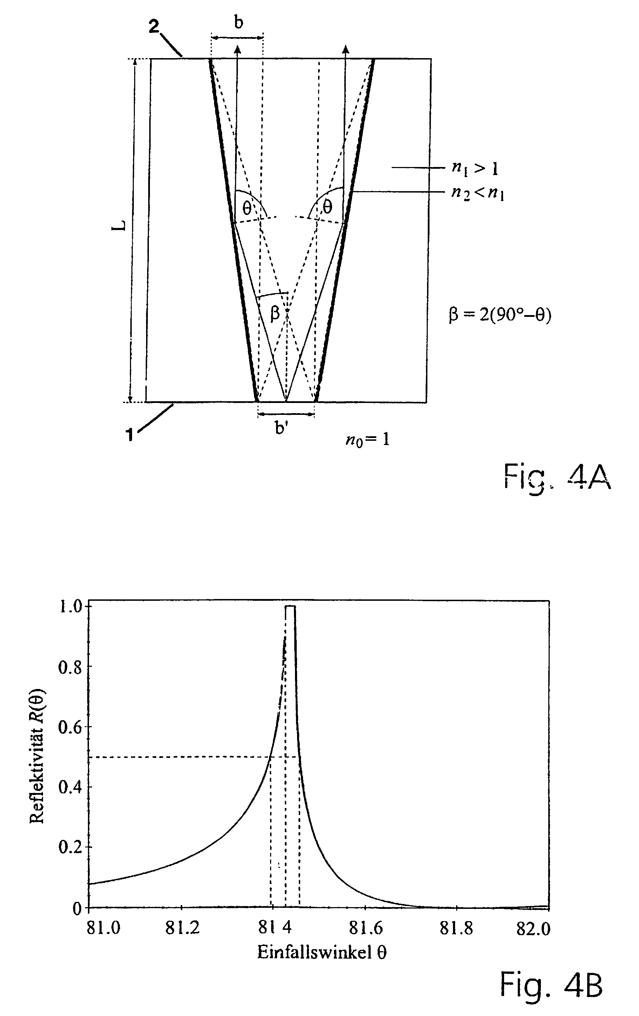

Es ist möglich, mit einer dreifachen Faltung Resonatoren aufzubauen, deren Endflächen in einer Ebene liegen. Figur 4A zeigt einen Resonator der Länge L mit zwei Resonatorendspiegeln 1, 2, wobei der eine Resonatorendspiegel 1 als Faltungselement mit einbezogen ist, wobei der Einfalls- bzw. Austrittswinkel mit β bezeichnet ist. Die beiden weiteren Spiegelelemente 3 sind so zu der Resonatorendfläche 1 orientiert, daß sich ein Reflexionswinkel θ ergibt. Die Auskopplung der Strahlung mit einer Strahlbreite b erfolgt an dem zweiten Resonatorspiegel 2, der eine antireflektierende Beschichtung aufweist.

Der Gesamtreflexionsgrad der Anordnung der Figur 4A ergibt sich aus Figur 4B. Anhand der Figur 4B ist ersichtlich, daß auch bei dieser Anordnung nur in einem stark eingeschränkten Winkelbereich ein hoher Gesamtreflexionsgrad und somit geringe Umlaufverluste vorliegen.

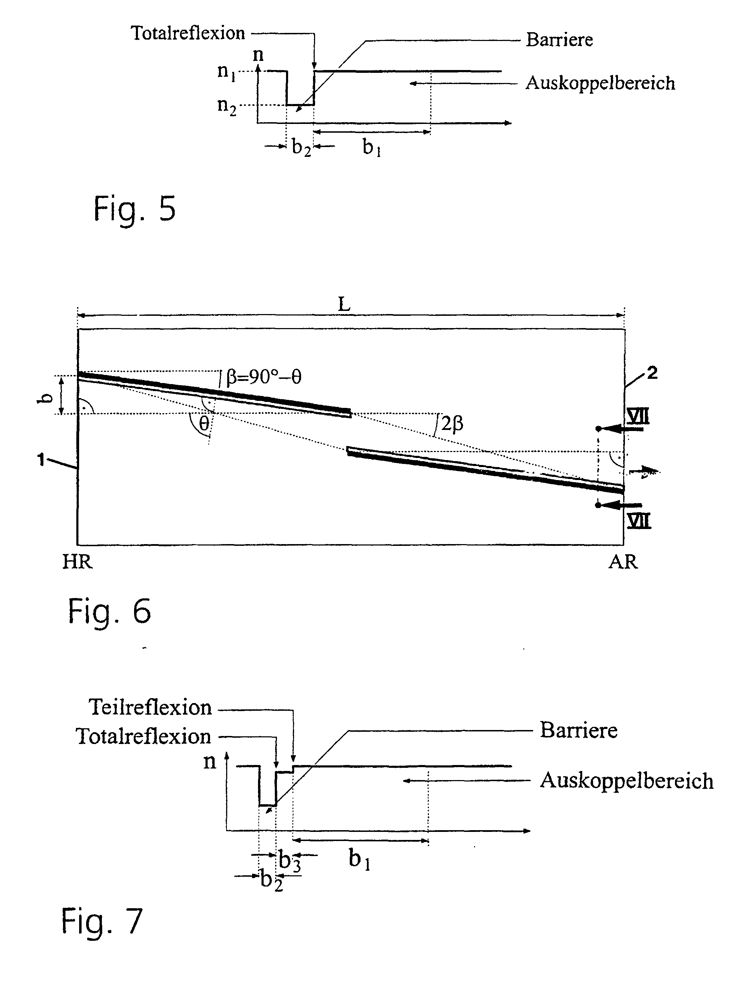

In Figur 5, die einen Schnitt entlang der Schnittlinie V-V der Figur 1 darstellt, ist eine gegenüber der Figur 1 dahingehend veränderte Anordnung gezeigt, daß Halbleitermaterialien eingesetzt sind. Die in Figur 5 gezeigte Ausführungsform ist exemplarisch für einen monolithischen Laser, zum Beispiel einen Diodenlaser. Entsprechend Figur 1 besteht der Resonator aus einem hoch reflektierenden Spiegel und einem teildurchlässigen Auskoppler. Das Halbleitermaterial weist einen Brechungsindex n₁ auf. Die Faltungsfiächen werden allerdings durch die Grenzflächen zu einem Halbleitermaterial mit Brechungsindex n₂< n₁ realisiert, wie anhand der Figur 5 zu erkennen ist.

Üblicherweise besitzen die beim Bau von Diodenlasern verwendeten Halbleitermaterialien Brechungsindizes, die deutlich größer als 1 sind (ungefähr ≈ 3,2 bis 3,7). Der Grenzwinkel für die Totalreflexion an der Außenfläche des Halbleiterkristalls ist daher klein. Unter Einbeziehung einer Kristallaußenfläche kann daher auch ein dreifach gefalteter Diodenlaserresonator realisiert werden, in der Weise, daß beide Endspiegel des Resonators auf einer vorderen Kristallfläche liegen, wie dies in Figur 4A angedeutet ist, wenn dort die jeweils angegebenen Brechungsindizes n₁, n₂ und n₀ berücksichtigt werden mit der Maßgabe n₁ > 1, n₂ < n₁ und n₀ = 1, wobei n₀ der Brechungsindex der umgebenden Atmosphäre ist.

Ein Problem bei hoch verstärkenden Lasern, insbesondere Diodenlasern, besteht in der Bildung von Filamenten infolge der Ladungsträgerdichte-Abhängigkeit von Brechungsindex und Verstärkung. Dies führt zur Inhomogenität des Brechungsindex und der Verstärkung und reduziert dadurch die erreichbare Strahlqualität. Eine reduzierte Filamentierung kann erreicht werden, indem durch geeignete Mechanismen die Laserstrahlung quer zur Resonatorachse ausgetauscht wird. Dies kann z.B. dadurch gelöst werden, daß die Faltungselemente mit einer zusätzlichen, plan-parallelen Schicht versehen werden, die für die auftreffende Strahlung transparent ist, und einen Teil der Strahlung, wie in einem Wellenleiter entlang den Faltungselementen, und damit quer zur Resonatorachse, transportiert.

In Figur 6 ist nun eine Anordnung gezeigt, bei der, im Vergleich zur Anordnung in Figur 1, die Faltungselemente mit einer zusätzlichen, plan-parallelen Schicht versehen sind.

Anhand der Figur 7, die einen Schnitt entlang der Schnittlinie VII-VII in Figur 6 zeigt, ist zu erkennen, daß die plan-parallele Schicht, beispielsweise im Fall eines Halbleiterlasers, durch eine zusätzliche Stufe im Brechungsindexprofil realisiert werden kann.

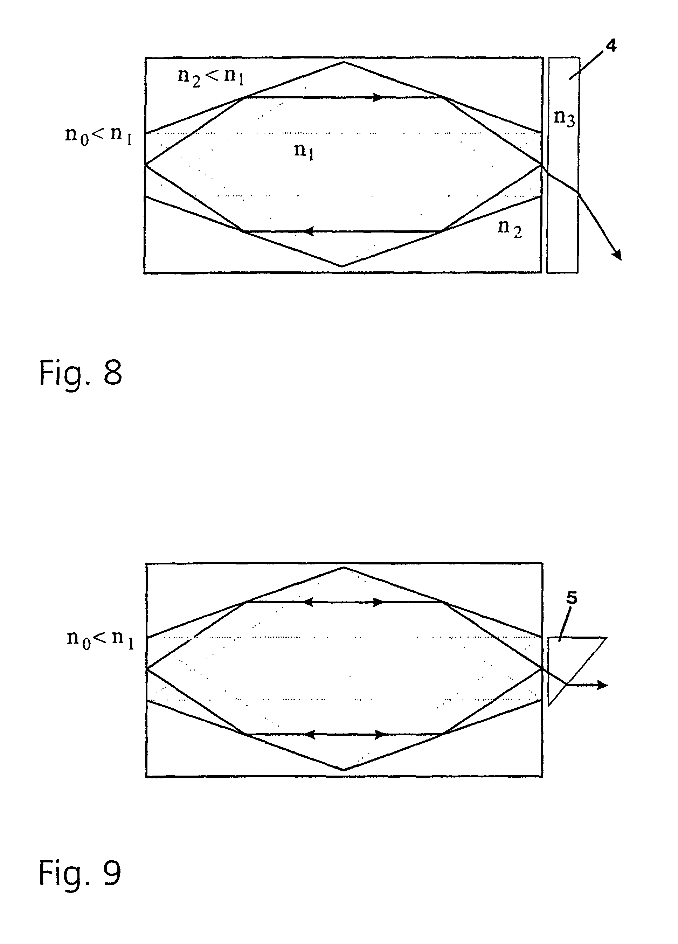

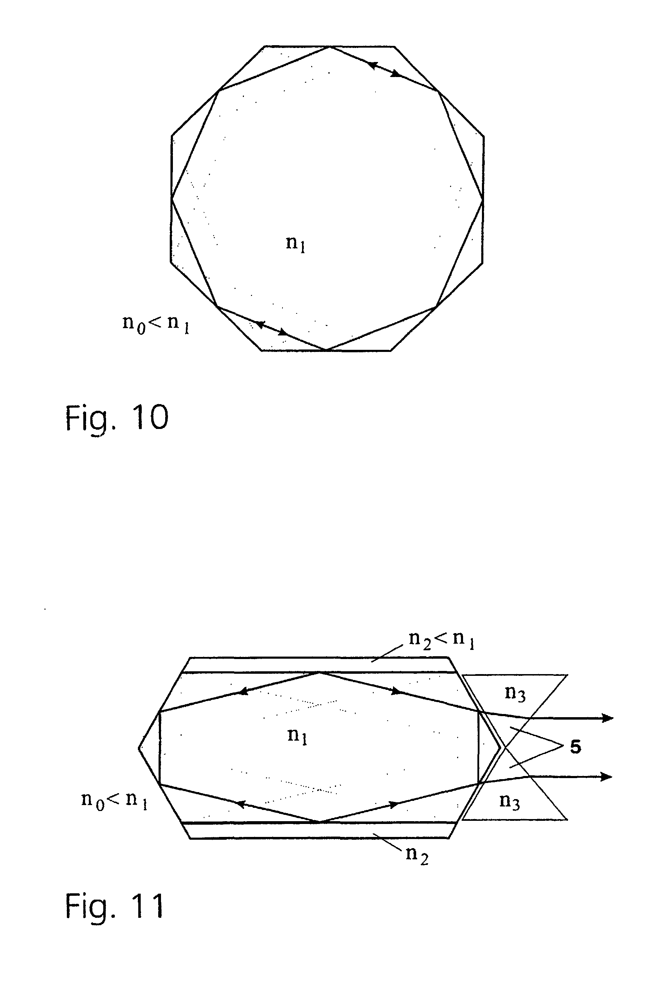

Um ein räumliches Hole-Burning (Loch-Brennen) zu vermeiden, kann ein Ringresonator mit laufender Welle aufgebaut werden, unter Verwendung jeweiliger Faltungselemente zur Einschränkung des Divergenzwinkels der Strahlung. Zwei beispielhafte Anordnungen sind in den Figuren 8 und 9 dargestellt. Die Grenzflächen des Lasermediums sind hierbei so beschaffen, daß alle Kantenflächen für die Laserstrahlung total reflektierend sind. Die Auskopplung der Laserstrahlung erfolgt über eine plan-parallele Platte 4 (Figur 8) oder ein Prisma 5 (Figur 9 ), die jeweils so zu dem Lasermedium positioniert sind, daß die Laserstrahlung durch Leckstrahlung ausgekoppelt werden kann. Weiterhin kann durch Anlegen von magnetischen Feldern die Strahlausbreitung des Lasermediums in einer umlaufenden Richtung erreicht werden. Für die Telekommunikation bzw. für Einsatzgebiete, bei denen eine hohe Integrationsrate gewünscht ist, sind Mikrolaser mit geringer Schwelle für den Laserbetrieb von großem Interesse. Entsprechend sind Mikrolaser mit kreisförmigem bzw. elliptischem Resonator von Interesse. Der Mikrolaser mit elliptischem Resonator ist im Vergleich zu Mikrolasern mit kreisförmigen Resonator zwar die Schwelle weitgehendst reduziert und eine höhere Ausgangsleistung erreicht, jedoch sind die Abstrahleigenschaften dieser Mikrolaser für viele Anwendungen nicht ausreichend. Um dieses Problem zu umgehen, werden daher für solche Fälle bevorzugt polygonförmige Resonatoren verwendet, wie er beispielsweise in Figur 10 schematisch dargestellt ist. Hierbei handelt es sich um einen Ringresonator, bei dem durch die interne Totalreflexion die Winkelselektion der Laserstrahlung gesteigert wird. Bei dem Beispiel des Ringsresonators, wie er in Figur 11 dargestellt ist, erfolgt die Auskopplung der Laserstrahlung durch zwei Prismen (mit Brechungsindex n₃), die hinsichtlich des Brechungsindex und der Dimensionierung so ausgelegt und so angeordnet werden, daß die Auskopplung durch Leckstrahlung erfolgt und darüberhinaus die Strahlung der beiden Umlaufrichtungen über die beiden Prismen 5 parallel zueinander erfolgt.

In den beschriebenen gefalteten Resonatoren kann die Richtungsselektion zusätzlich durch eine geeignete Geometrie der angeregten Zone (Verstärkungsbereich) unterstützt werden. Eine Möglichkeit hierzu besteht darin, den Verstärkungsbereich dem durch die Reflexion an den Faltungselementen 3 gewinkelten Strahlverlauf anzupassen, indem nur das Volumen als Verstärkungsbereich ausgebildet wird, welches von Strahlen durchsetzt wird, die senkrecht auf den Auskoppelspiegel treffen. Hierbei können die der Faltung folgenden Strahlen eine maximale Verstärkung aufweisen, während alle übrigen Strahlen in den nicht angeregten Bereichen abgeschwächt werden. Durch eine solche Maßnahme wird außerdem der Wirkungsgrad der Resonatoranordnung bzw. des Lasers verbessert, da Anregungs- und Modenvolumen näherungsweise gleich sind. Bei Diodenlasern kann die Geometrie des Verstärkungsbereichs beispielsweise durch die Form der elektrischen Kontakte bestimmt werden.

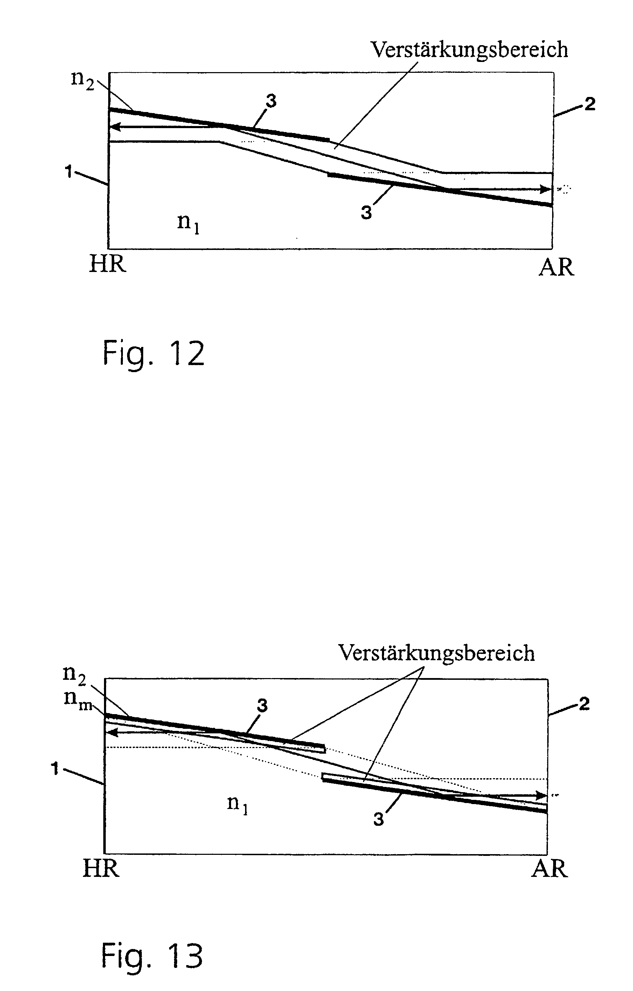

In Figur 13 ist eine Resonatoranordnung gezeigt, bei der die Verstärkung auf schmale Streifen vor den Faltungselementen 3, konzentriert wird. Hierzu wird entsprechend dem Aufbau der Figur 6 eine plan-parallele Schicht, den Faltungselementen zugeordnet, vorgesehen, die allerdings in der Ausführungsform der Figur 13 als Verstärkungszone ausgebildet ist. Gerade in Verbindung mit Diodenlasern, die nach diesem Prinzip aufgebaut werden, kann der Einfluß der Filamentierung reduziert werden. Weiterhin erfolgt die Strahlungsauskopplung in diesem Fall über eine Fläche, die groß im Vergleich zum Querschnitt der Verstärkungsbereiche ist, wodurch die Intensitätsbelastung der Austrittsfläche reduziert werden kann.

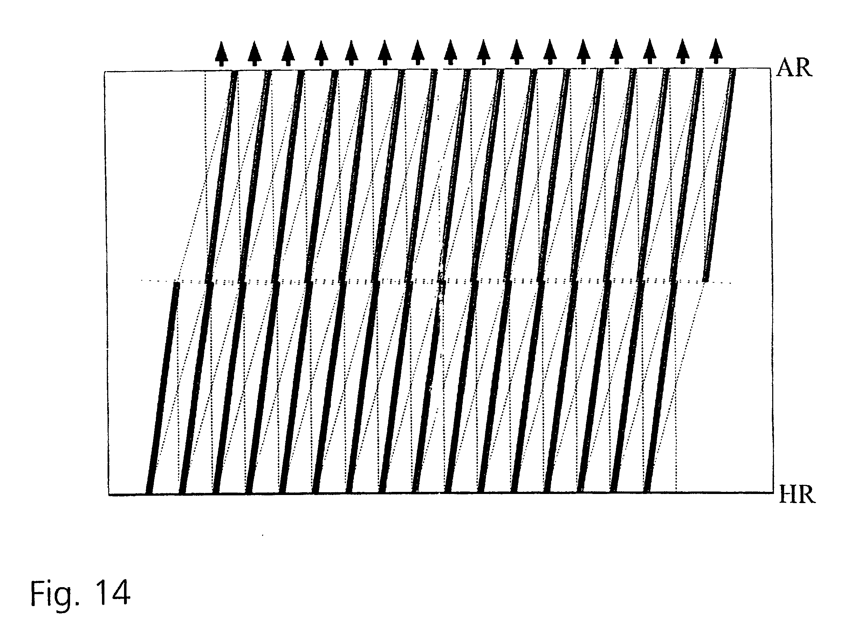

Figur 14 zeigt eine Anordnung, bei der zur Erhöhung der Ausgangsleistung mehrere Faltungsanordnungen, wie sie beispielsweise in Figur 1 oder 13 dargestellt sind, zu einem Feld bzw. Array zusammengesetzt werden können. Falls die Verstärkung nur in schmalen Streifen erfolgt, wie dies beispielsweise in der Anordnung der Figur 13 gezeigt ist, so kann infolge der verminderten, thermischen Belastung, mit der Anordnung nach Figur 14 ein Füllfaktor des Arrays von nahezu 1 erreicht werden.

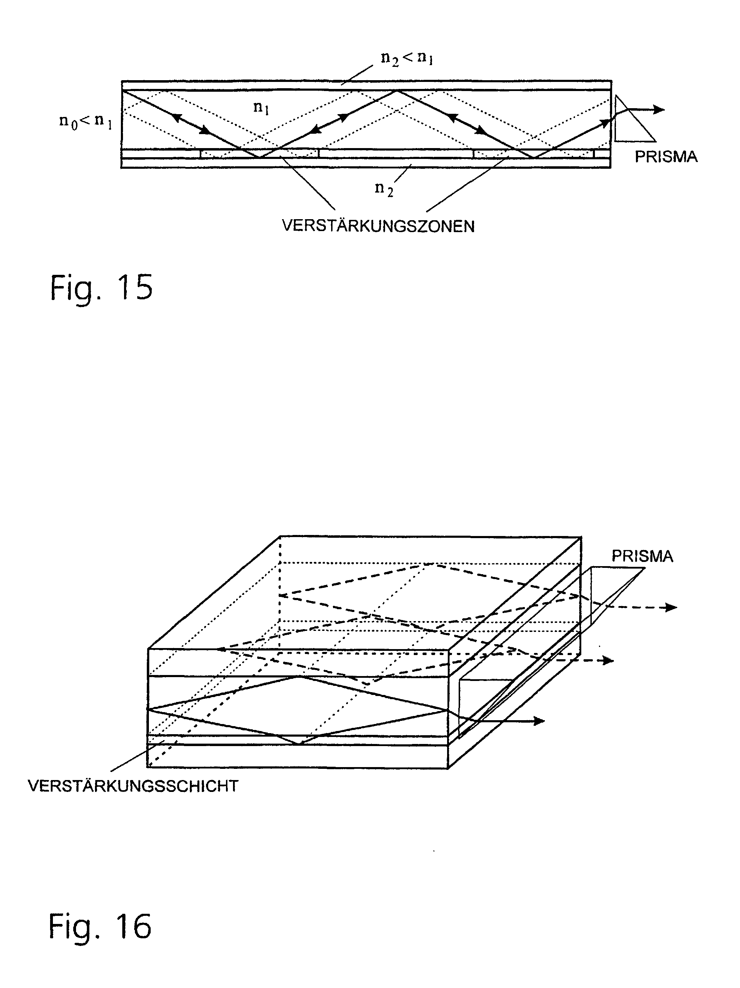

Für den Fall, daß die Verstärkungszone wie eine dünne Schicht ausgebildet ist, wie z.B. bei einem Halbleiterlaser, kann die Faltung auch in der Ebene senkrecht zu der Verstärkungsschicht realisiert werden. Bei Diodenlasern können die Verstärkungsschichten wie bei Kantenemittern oder Oberflächen- bzw. Surface-Emittern realisiert werden. Eine Ausführungsform eines derartigen Lasers ist in Figur 16 gezeigt. In der Anordnung der Figur 16 erfolgt die Verstärkung in einer durchgehenden Verstärkungsschicht, während die winkelselektive Faltung an der Grenzfläche zu den Medien mit Brechungsindizes n₀ < n₁ und n₂ < n₁ erfolgt.

Im Vergleich zu normalen Kantenemittern, wo der austretende Strahl eine Strahlhöhe von 1 µm hat (in Bezug auf die Diodenlaser), kann durch Vergrößerung der Höhe des so gebildeten Resonators eine Austrittsstrahlhöhe von einigen µm bis zu einigen 100 µm erreicht werden. Dadurch wird die Intensitätsbelastung der Austrittsfläche weitgehend reduziert und somit die durch deren Zerstörschwelle gegebene Leistungsgrenze erhöht.

Falls höhere Verstärkungsfaktoren erforderlich sind, können, wie in Figur 15 gezeigt ist, mehrere Verstärkungszonen axial hintereinander angeordnet werden. Die Verstärkungszonen können sich an der Unter- und/oder Oberseite des strahlungsführenden Bereichs befinden.

Zur Erhöhung der Ausgangsleistung können die vorstehend erläuterten Resonatoren mit entsprechenden Verstärkungszonen in Form eines Arrays angeordnet werden, wie dies auch in Figur 14 anhand eines Arrays, das aus einzelnen, linearen, optischen Resonatoren mit einer zweifachen Faltung besteht, erläutert ist.

## Patentansprüche

1. Resonatoranordnung mit mindestens zwei Faltungselementen (3) zur Faltung des Strahlengangs, wobei die Faltungselemente zur Einschränkung des Divergenzwinkels der Strahlung dienen,
die jeweilige Faltung durch Reflexion an einer reflektierenden Fläche des jeweiligen Faltungselements (3) hervorgerufen wird, **dadurch gekennzeichnet, daß**
die Strahlachse der Strahlung und die Flächennormale der jeweillgen reflektierenden Fläche unter einem Winkel θ zueinanderstehen, der größer als der Grenzwinkel für Totalreflexion θ_{T} ist, allerdings kleiner als die Summe aus Grenzwinkel für Totalreflexion θ_{T} und Divergenzwinkel der Strahlung ist.

2. Resonatoranordnung nach Anspruch 1, **dadurch gekennzeichnet, daß** die jeweilige reflektierende Fläche durch die Grenzfläche zwischen Materialien mit unterschiedlichen Brechungsindizes gebildet ist.

3. Resonatoranordnung nach Anspruch 1, **dadurch gekennzeichnet, daß** in der Resonatoranordnung zumindest teilweise eine Wellenführung durch eine Wellenleiterstruktur erfolgt und daß die jeweilige reflektierende Fläche durch eine Änderung des Profils der Wellenleiterstruktur gebildet ist.

4. Resonatoranordnung nach Anspruch 1, **dadurch gekennzeichnet, daß** mindestens die Faltungselemente (3) so zueinander angeordnet sind, daß ein Resonatorendspiegel und ein Resonatorauskoppler in einer Ebene liegen.

5. Resonatoranordnung nach Anspruch 1, **dadurch gekennzeichnet, daß** mindestens eines der Faltungselemente (3) mit einer für die Strahlung teiltransparenten, plan-parallelen Schicht versehen ist.

6. Resonatoranordnung nach Anspruch 1, **dadurch gekennzeichnet, daß** der Verstärkungsbereich nur einen Teil des durch die einfache oder mehrfache Faltung gebildeten Resonatorvolumens einnimmt.

7. Resonatoranordnung nach Anspruch 1, **dadurch gekennzeichnet, daß** in dem Resonatorvolumen liegende Bereiche, die nicht als Verstärkungszone ausgebildet sind, mit zusätzlicher Absorption versehen werden.

8. Resonatoranordnung nach Anspruch 1, **dadurch gekennzeichnet, daß** eine Verstärkungszone vorgesehen ist, die schichtartig ausgebildet ist, und daß die Faltung in einer Ebene senkrecht zu der Schicht vorgenommen ist.

9. Resonatoranordnung nach Anspruch 1, **dadurch gekennzeichnet, daß** im Bereich einzelner Faltungselemente (3) jeweils ein getrennter Verstärkungsbereich angeordnet ist.

10. Resonatoranordnung nach einem der Ansprüche 1 bis 9, **dadurch gekennzeichnet, daß** mindestens eine der reflektierenden Flächen gekrümmt ist.

11. Resonatoranordnung nach Anspruch 1, **dadurch gekennzeichnet, daß** mindestens drei Faltungselemente (3) vorgesehen sind, die so angeordnet sind, daß ein Ringresonator gebildet wird.

12. Resonatoranordnung nach Anspruch 1, **dadurch gekennzeichnet, daß** parallel zu den reflektierenden Flächen mindestens eines Teils der Faltungselemente (3) ein Verstärkungsmedium angeordnet ist.

13. Resonatoranordnung nach Anspruch 1 und 5, **dadurch gekennzeichnet, daß** die planparallele Schicht durch eine weitere Grenzfläche zwischen Medien mit unterschiedlichen Brechungsindizes gebildet ist.

## Claims

1. A resonator arrangement comprising at least two folding elements (3) for folding the beam path, said folding elements serving to restrict the divergence angle of the radiation,
the respective folding being caused by reflection on a reflecting surface of the respective folding element (3), **characterized in that**
the beam axis of the radiation and the surface normal of the respective reflecting area being positioned at an angle θ relative to each other that is greater than the critical angle for the total reflection θᵣ but smaller than the sum of the critical angle for total reflection θᵣ and divergence angle of the radiation.

2. The resonator arrangement according to claim 1, **characterized in that** the respective reflecting surface is formed by a boundary surface between materials having different refractive indices.

3. The resonator arrangement according to claim 1, **characterized in that** in said resonator arrangement wave guiding is carried out at least in part by way of a waveguide structure, and that the respective reflecting surface is formed by changing the profile of said waveguide structure.

4. The resonator arrangement according to claim 1, **characterized in that** at least said folding elements (3) are arranged relative to one another such that a resonator end mirror and a resonator output coupler are positioned in one plane.

5. The resonator arrangement according to claim 1, **characterized in that** at least one of the folding elements (3) is provided with a plane-parallel layer which is partially transparent for the radiation.

6. The resonator arrangement according to claim 1, **characterized in that** the gain region only occupies part of the resonator volume formed by simple or multiple folding.

7. The resonator arrangement according to claim 1, **characterized in that** regions which are positioned in the resonator volume and are not designed as a gain zone are provided with additional absorption.

8. The resonator arrangement according to claim 1, **characterized in that** a gain zone is provided which is layered, and that folding is carried out in a plane perpendicular to the layer.

9. The resonator arrangement according to claim 1, **characterized in that** a separate gain region is respectively arranged in the area of individual folding elements (3).

10. The resonator arrangement according to any one of claims 1 to 9, **characterized in that** at least one of said reflecting surfaces is curved.

11. The resonator arrangement according to claim 1, **characterized in that** at least three folding elements (3) are provided which are arranged such that a ring resonator is formed.

12. The resonator arrangement according to claim 1, **characterized in that** a gain medium is arranged in parallel with said reflecting surfaces of at least part of said folding elements (3).

13. The resonator arrangement according to claims 1 and 5, **characterized in that** the plane-parallel layer is formed by a further boundary surface between media having different refractive indices.

## Revendications

1. Dispositif résonateur comportant au moins deux éléments de repliement (3) pour replier la marche des rayons optiques, les éléments de repliement servant à limiter l'angle de divergence des rayons,
chaque repliement étant produit par réflexion sur une surface réfléchissante de l'élément de repliement (3) correspondant,
**caractérisé en ce que**
l'axe du rayon et la normale à la surface réfléchissante respective font entre eux un angle θ supérieur à l'angle limite pour la réflexion totale θ_{T}, mais inférieur à la somme de l'angle limite de la réflexion totale θ_{T} et de l'angle de divergence du rayon.

2. Dispositif résonateur selon la revendication 1,
**caractérisé en ce que**
la surface réfléchissante respective est formée par la surface limite entre les matières à indice de réfraction différent.

3. Dispositif résonateur selon la revendication 1,
**caractérisé en ce que**
dans le dispositif résonateur, il y a au moins en partie un guidage d'ondes par une structure guide d'ondes, et
la surface réfléchissante respective est formée par une variation du profil de la structure de guide d'ondes.

4. Dispositif résonateur selon la revendication 1,
**caractérisé en ce qu'**
au moins les éléments de repliement (3) sont disposés les uns par rapport aux autres pour qu'un miroir d'extrémité du résonateur et un découpleur de résonateur se situent dans un plan.

5. Dispositif résonateur selon la revendication 1,
**caractérisé en ce qu'**
au moins l'un des éléments de repliement (3) est muni d'une couche parallèle plane partiellement transparente aux rayons.

6. Dispositif résonateur selon la revendication 1,
**caractérisé en ce que**
la plage d'amplification n'occupe qu'une partie du volume du résonateur formé par un repliement simple ou multiple.

7. Dispositif résonateur selon la revendication 1,
**caractérisé en ce que**
les zones situées dans le volume du résonateur et qui ne sont pas réalisées comme zones d'amplification, présentent une absorption supplémentaire.

8. Dispositif résonateur selon la revendication 1,
**caractérisé par**
une zone d'amplification de forme stratifiée et le repliement se fait dans un plan perpendiculaire à la couche.

9. Dispositif résonateur selon la revendication 1,
**caractérisé en ce que**
dans la zone des divers éléments de repliement (3), on a chaque fois une zone d'amplification séparée.

10. Dispositif résonateur selon l'une quelconque des revendications 1 à 9,
**caractérisé en ce qu'**
au moins l'une des surfaces réfléchissantes est courbe.

11. Dispositif résonateur selon la revendication 1,
**caractérisé par**
au moins trois éléments de repliement (3) disposés pour former un résonateur en anneau.

12. Dispositif résonateur selon la revendication 1,
**caractérisé par**
un milieu amplificateur en parallèle aux surfaces réfléchissantes d'au moins une partie des éléments de repliement (3).

13. Dispositif résonateur selon l'une quelconque des revendications 1 et 5,
**caractérisé en ce que**
la couche plane parallèle est formée par une autre surface limite entre les milieux à indice de réfraction différent.
